## Europäisches Patentamt
## European Patent Office
## Office européen des brevets

(19)

(11) Veröffentlichungsnummer: **0 048 864**
**B1**

(12)

# EUROPÄISCHE PATENTSCHRIFT

(45) Veröffentlichungstag der Patentschrift:
**16.01.85**

(21) Anmeldenummer: **81107153.9**

(22) Anmeldetag: **10.09.81**

(51) Int. Cl.⁴: **H 01 J 37/04, H 01 J 37/00**

(54) **Korpuskularstrahl-Austastsystem.**

(30) Priorität: **29.09.80 DE 3036659**

(43) Veröffentlichungstag der Anmeldung:
**07.04.82 Patentblatt 82/14**

(45) Bekanntmachung des Hinweises auf die Patenterteilung:
**16.01.85 Patentblatt 85/3**

(84) Benannte Vertragsstaaten:
**DE FR GB NL**

(56) Entgegenhaltungen:
**FR - A - 1 164 993
US - A - 3 801 792
US - A - 4 130 761**

**JAPANESE JOURNAL OF APPLIED PHYSICS, Band 12, Nr. 2, Februar 1973. Seiten 163-166, Tokyo, JP. T. ICHINOKAWA et al.: "Simple electron monochromator of three-diaphragm einzel lens"
ZEITSCHRIFT FÜR NATURFORSCHUNG, Band 17a, Nr. 12, 1962, Seiten 1066-1070 Tübengen, DE. K. BRACK: "Über eine Anordnung zur Filterung von Elektroneninterferenzen"**

(73) Patentinhaber: **Siemens Aktiengesellschaft, Berlin und München Wittelsbacherplatz 2, D-8000 München 2 (DE)**

(72) Erfinder: **Plies, Erich, Dr.rer.nat., Dipl.-Phys., Deisenhofenerstrasse 79C, D-8000 München 90 (DE)**

ACTORUM AG

## Beschreibung

Die Erfindung betrifft ein Korpuskularstrahl-Austastsystem nach dem Oberbegriff des Anspruchs 1.

Beim Schreiben mit Elektronen oder Ionen muss der Korpuskularstrahl nach Massgabe des zu belichtenden Musters hell und dunkel getastet werden. Bei Korpuskularstrahl-Messgeräten wird der Korpuskularstrahl mit Hilfe eines Strahlaustastsystems pulsförmig unterbrochen.

Bisher wurden zur Strahlaustastung meist Plattenkondensatoren oder Wanderwellenstrukturen verwendet. Eine Dreielektroden – Einzellinse, deren Elektroden nach Art einer Filterlinse gestaltet sind, ist aus dem Artikel in «Zeitschrift für Naturforschung», Band 17a, Heft 12 (1962), Seiten 1066–1070 bekannt.

Der Erfindung liegt die Aufgabe zugrunde, ein Korpuskularstrahl-Austastsystem zur Erzeugung hochfrequenter Korpuskularpulse mit günstigen elektronenoptischen Abbildungseigenschaften anzugeben.

Diese Aufgabe wird erfindungsgemäss durch ein Korpuskularstrahl-Austastsystem nach dem Anspruch 1 gelöst. Durch eine genügend grosse Zusatzspannung, deren Vorzeichen dem Vorzeichen der physikalischen Ladung der geladenen Korpuskeln entspricht, an der Mittelelektrode kann der Korpuskularstrahl gesperrt werden. Diese Austastlinse bewirkt nur eine Strahlversetzung, wobei das reelle Quellenbild in der Linsenmitte liegt.

Bei einem erfindungsgemässen Korpuskularstrahl-Austastsystem wird der Korpuskularstrahl nicht über eine Austastblende gewischt, wie dies bei einer Strahlaustastung mit Plattenkondensatoren oder Wanderwellenstrukturen der Fall ist. Vielmehr wird bei einem erfindungsgemässen Korpuskularstrahl-Austastsystem der Korpuskularstrahl auf- und zugedreht. Ein erfindungsgemässes Korpuskularstrahl-Austastsystem ermöglicht einen kleinen Durchmesser des Korpuskularstrahls, einen kleinen Austasthub und ein dynamisches Sperren des Korpuskularstrahls in einer Weise, die eine wohlgeformte Korpuskular-Sonde zulässt und rechteckförmige Korpuskularstrahlpulse möglichst wenig beeinträchtig.

Obwohl im folgenden Korpuskularstrahl-Austastsysteme für den Betrieb mit negativ geladenen Korpuskeln beschrieben werden, sind erfindungsgemässe Korpuskularstrahl-Austastsysteme selbstverständlich nicht auf den Betrieb mit negativ geladenen Korpuskeln beschränkt.

Aufgrund der im Anspruch 1 angegebenen Strahlengangs ist der Strahldurchmesser innerhalb der Linse klein und die Linse kann mit kleinen radialen Abmessungen dimensioniert werden, was eine niedrige Kapazität der Linse liefert. Abschätzungen ergeben, dass eine Kapazität unter 3 pF möglich ist.

Vorteilhafterweise sind die Elektroden nach Art einer Filterlinse konstruiert, damit der Potentialsattel in radialer Richtung möglichst flach ist.

Dann genügt ein geringer Spannungshub an der Mittelelektrode, um den Strahl zu sperren.

Das kathodenbezogene Potential des Sattelpunktes muss im Sperrbetrieb nicht nur Null, sondern leicht negativ sein, da die Korpuskeln bei der Emission eine endliche Austrittsenergie erhalten haben.

Im Umschaltbereich von Durchlass auf Sperrung wandert das Quellenbild zwangsläufig auf der optischen Achse in Richtung Quelle. Wird die Quelle auf das Target abgebildet, so führt dies beim Austasten zwangsläufig zum «Atmen» der Sonde. Diese unerwünschte Vergrösserung der Sonde wird vorteilhafterweise vermieden, wenn eine Austast-Lochblende in einem Zwischenbild der Quelle (nach der Austastlinse) angeordnet ist. Der Durchmesser $d_{AB}$ der Austast-Lochblende wird gemäss $d_{AB} = M \cdot d_Q$ dem Quellendurchmesser $d_Q$ angepasst, wobei M die Vergrösserung der Quelle bis zum Zwischenbild ist. Mit Hilfe dieser Austastblende bleibt der Durchmesser des Sondenflecks während des Austastvorgangs konstant, lediglich die Stromstärke ändert sich. Die Austastblende ist überflüssig, wenn nicht das Quellenbild, sondern Formstrahlblenden, die nach dem Austastsystem angeordnet sind, auf das Target abgebildet werden.

Ausser dem hochfrequenten Austastsignal kann vorteilhafterweise an die Mittelelektrode noch eine negative Zusatzgleichspannung angelegt werden, so dass schon im normalen Durchlassbetrieb ein Teil der niederenergetischen Korpuskeln in der Linse ausgefiltert wird.

Aufgrund des axialen Farbfehlers der Austastlinse und der nachfolgenden Linse, wobei sich die Farbfehler aufaddieren, wirkt die Austast-Lochblende gleichzeitig als Energieselektionsblende. Die Energieverteilung der Korpuskeln wird durch diese Austast-Lochblende von der hochenergetischen und nochmals von der niederenergetischen Seite her beschnitten. Der Monochromatoreffekt ist besonders dann wünschenswert, wenn im Strahlerzeuger eine hohe anomale Energieverbreiterung (Boersch-Effekt) entstanden ist. Es ist nicht zu erwarten, dass sich die Energiebreite des Strahls nach der Filterung wieder ähnlich stark aufgrund des Boersch-Effekts erhöht, da die Stromstärke nach der Filterung wesentlich kleiner ist:

1. Durch Ausblenden zwischen Strahlerzeuger und Strahlaustastsystem und
2. durch die Filterung der Korpuskeln.

Ausserdem wird nach der Austast-Lochblende nur noch auf voller Strahlspannung gearbeitet, wodurch die anomale Energieverbreiterung ebenfalls kleiner bleibt.

Die Erfindung ist in der Zeichnung dargestellt und wird im folgenden näher erläutert.

Fig. 1 ist eine schematische Darstellung einer elektrostatischen Dreielektroden-Strahlaustastlinse mit zugehörigem Strahlengang im Durchlassbetrieb.

Fig. 2 zeigt die Potentialverläufe in der elektrostatischen Austastlinse:

a) längs der optischen Achse,

b) senkrecht zur optischen Achse in der Linsenmitte.

Fig. 3a zeigt den Strahlengang im Durchlassbetrieb, im Sperrbetrieb und im Übergangsbereich.

Fig. 3b zeigt den Verlauf des zugehörigen Austastimpulses.

Fig. 4 zeigt die Verkleinerung der Energiebreite durch die Austastlinse mit zusätzlicher Austast-Lochblende:

a) Strahlengang im Durchlassbetrieb für Elektronen verschiedener Energie,

b) Energieverteilung vor und nach der Filterung.

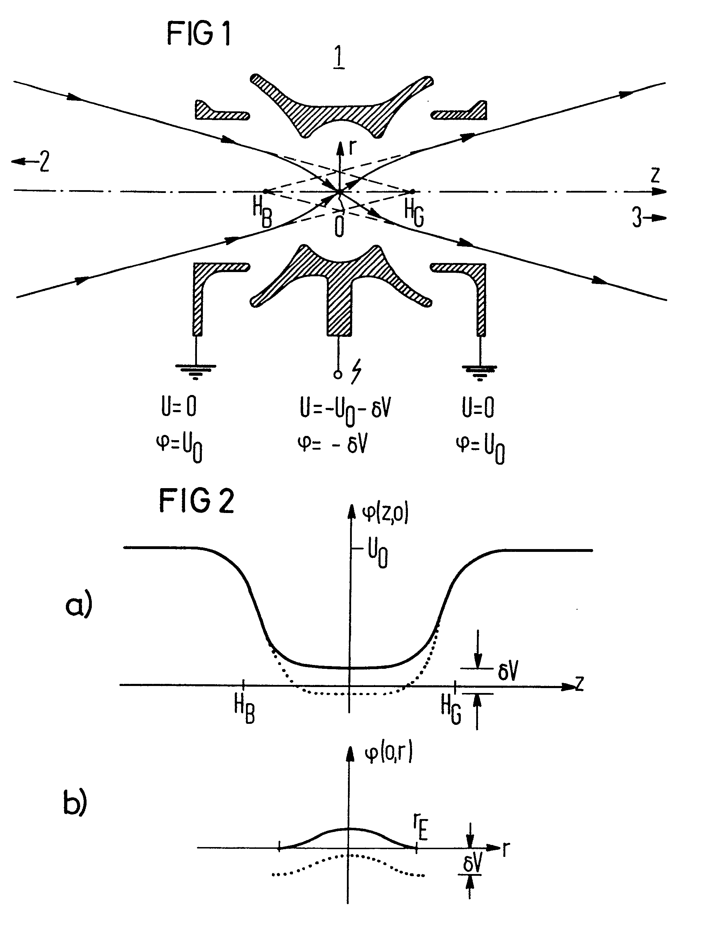

Fig. 1 ist eine schematische Darstellung einer elektrostatischen Dreielektroden-Strahlaustastlinse mit zugehörigem Strahlengang im Durchlassbetrieb ($\delta V$ = Null). Die Ordinate ist stark überhöht. $H_G$ ist der gegenstandsseitige Hauptpunkt, $H_B$ ist der bildseitige Hauptpunkt, $\varphi$ ist das kathodenbezogene Potential, U ist das anodenbezogene Potential, $U_0$ ist die Beschleunigungsspannung und $-\delta V$ ist das elektrische Strahlaustastsignal. Die beiden äusseren Elektroden liegen auf Anodenpotential, während das kathodenbezogene Potential der Mittelelektrode vom elektrischen Strahlaustastsignal gesteuert wird. Der mit 2 bezeichnete Pfeil zeigt zur Quelle und der mit 3 bezeichnete Teil zeigt zum Target. Es ist ein zylindrisches Koordinatensystem mit den Koordinaten r und z eingeführt, eine dritte Koordinate ist nicht nötig wegen der Zylindersymmetrie der Anordnung. Mit O ist der Ursprung des Koordinatensystems bezeichnet.

Die Austastlinse 1 wird so in den Strahlengang eingefügt, dass ihr gegenstandsseitiger Knotenpunkt $K_G$, der hier gleich dem gegenstandsseitigen Hauptpunkt $H_G$ ist, mit dem virtuellen Quellenbild zusammenfällt. Wie aus Fig. 1 ersichtlich ist, bewirkt die Austastlinse 1 nur eine Strahlversetzung, wobei das reelle Quellenbild in der Linsenmitte liegt.

Fig. 2 zeigt die Potentialverläufe in der elektrostatischen Austastlinse 1. Fig. 2a zeigt den Potentialverlauf längs der optischen Achse und Fig. 2b zeigt den Potentialverlauf senkrecht zur optischen Achse in der Linsenmitte. Ausgezogene Kurven entsprechen dem Durchlassbetrieb, punktierte Kurven entsprechen dem Sperrbetrieb. Die Elektroden der Austastlinse 1 müssen nach Art einer Filterlinse konstruiert sein, damit der Potentialsattel in radialer Richtung möglichst flach ist. Nur dann genügt ein geringer Spannungshub der Mittelelektrode, um den Strahl zu sperren. Das Design einer Filterlinse ist in Fig. 1 dargestellt. Mit $r_E$ ist der Innenradius der Elektrode in der Linsenmitte bezeichnet.

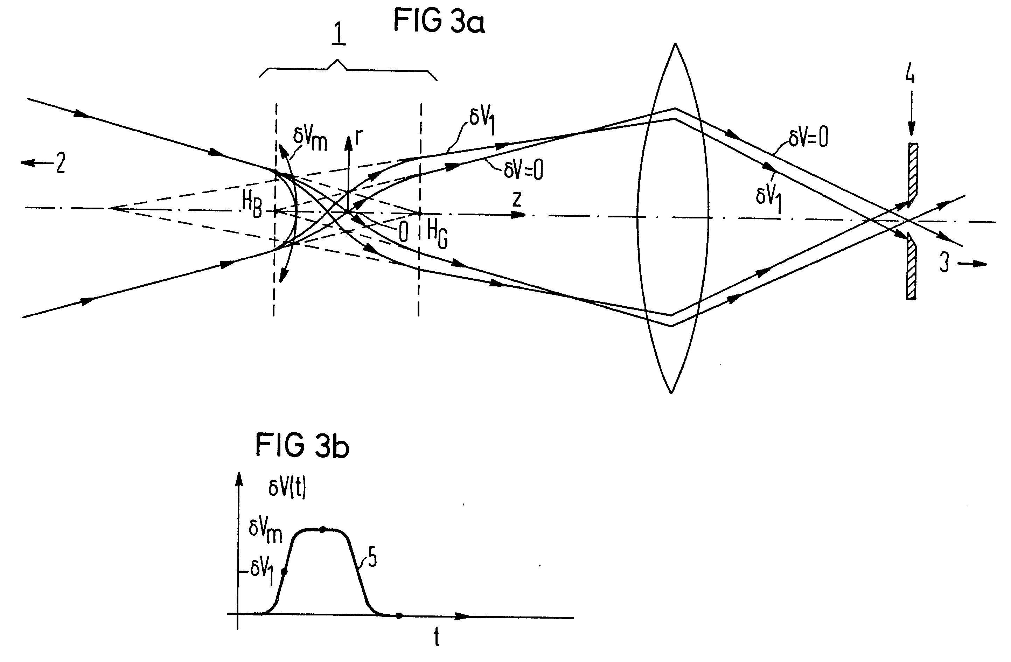

Fig. 3a zeigt den Strahlengang im Durchlassbetrieb ($\delta V$ = Null), im Sperrbetrieb ($\delta V = V_m$) und im Übergangsbereich ($\delta V = V_1$). Fig. 3b zeigt den Verlauf des zugehörigen Austastimpulses mit einem Spannungshub $\delta V_m$ für den Sperrbetrieb und einem Spannungshub $\delta V_1$ für den Übergangsbereich. Im Umschaltbereich von Durchlass auf Sperrung wandert das Quellenbild zwangsläufig auf der optischen Achse in Richtung Quelle 2. Wird die Quelle 2 auf das Target 3 abgebildet, so führt dies beim Austastvorgang zwangsläufig zum «Atmen» der Sonde. Diese unerwünschte Vergrösserung der Sonde wird vermieden, wenn die Austast-Lochblende 4 in einem Zwischenbild der Quelle nach der Austastlinse angeordnet ist. Der Durchmesser $d_{AB}$ der Austast-Lochblende 4 ist gemäss $d_{AB} = Md_Q$ dem Quellendurchmesser $d_Q$ angepasst, wobei M die Vergrösserung der Quelle 2 bis zum Zwischenbild ist.

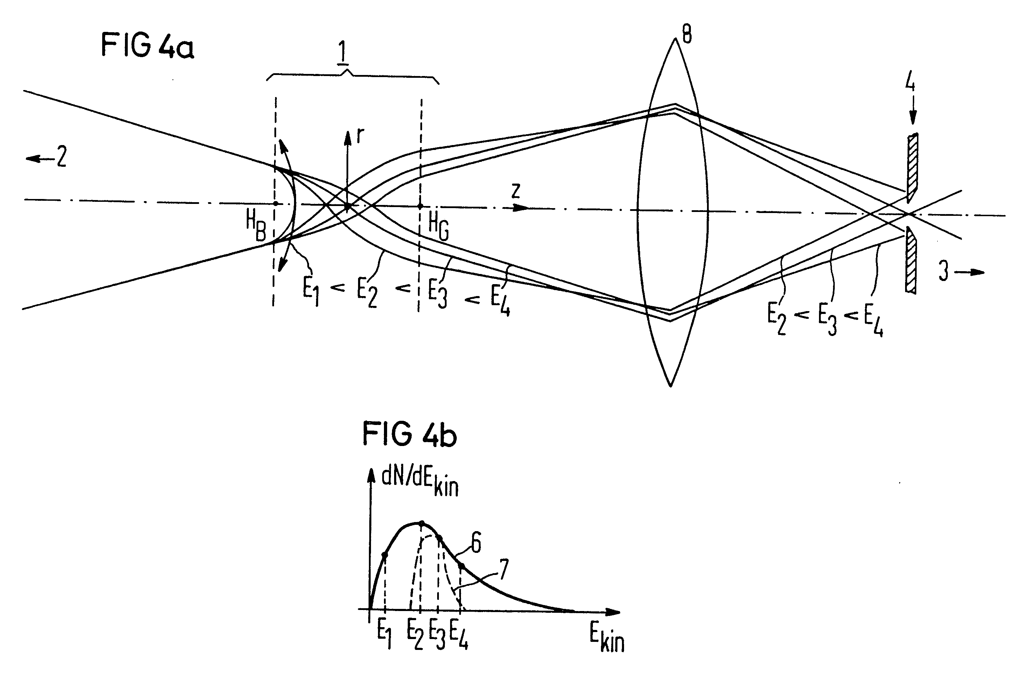

Fig. 4 zeigt die Verkleinerung der Energiebreite durch die Austastlinse 1 mit zusätzlicher Austast-Lochblende 4. Fig. 4a zeigt den Strahlengang im Durchlassbetrieb für Korpuskeln verschiedener Energie und Fig. 4b zeigt die Energieverteilung vor und nach der Filterung. Ausser dem hochfrequenten Austastsignal kann an die Mittelelektrode noch eine negative Zusatzgleichspannung angelegt werden, so dass schon im normalen Durchlassbetrieb ein Teil der niederenergetischen Elektronen in der Austast-Linse 1 ausgefiltert wird. In Fig. 4a ist dargestellt, dass Korpuskeln mit der Energie $E_1$ auf diese Weise ausgefiltert werden. Aufgrund des axialen Farbfehlers der Austastlinse 1 und der nachfolgenden Linse 8, wobei sich die axialen Farbfehler aufaddieren, wirkt die Austast-Lochblende 4 gleichzeitig als Energieselektionsblende: Korpuskeln mit einer relativ niedrigen Energie $E_2$ und mit einer relativ hohen Energie $E_4$ werden von der Austast-Lochblende 4 nicht durchgelassen. In Fig. 4b ist die Energieverteilung 6 vor der Filterung und die Energieverteilung 7 nach der Filterung dargestellt. Die Energieverteilung der Korpuskeln wird durch die Austast-Lochblende 4 von der hochenergetischen und nochmals von der niederenergetischen Seite beschnitten. Der Monochromatoreffekt ist besonders dann wünschenswert, wenn im Strahlerzeuger eine hohe anomale Energieverbreiterung (Boersch-Effekt) entstanden ist. Es ist nicht zu erwarten, dass sich die Energiebreite 7 nach der Filterung wieder ähnlich stark aufgrund des Boersch-Effekts erhöht, da die Stromstärke wesentlich kleiner ist. Ausserdem wird nach der Austast-Lochblende 4 nur noch auf voller Strahlspannung gearbeitet, wodurch die anomale Energieverbreiterung ebenfalls kleiner bleibt.

## Patentansprüche

1. Korpuskularstrahl-Austastsystem zur Erzeugung einer gepulsten Korpuskularstrahl-Sonde, gekennzeichnet durch eine elektrostatische Dreielektroden-Einzellinse (1) als Austastlinse, deren Elektroden nach Art einer Filterlinse gestaltet sind, wobei der im Durchlassbetrieb etwa auf dem Potential der Strahlquelle liegenden Mittelelektrode das Austastsignal über einen Kondensator zugeführt wird, und wobei diese Austastlinse so in den Strahlengang eingefügt ist, dass der gegenstandsseitige Hauptpunkt $H_G$ mit dem virtuellen Quellenbild, das zu dieser Austastlinse gehört, zusammenfällt.

2. Korpuskularstrahl-Austastsystem nach Anspruch 1, dadurch gekennzeichnet, dass die Austastlinse kleine radiale Abmessungen und eine niedrige Kapazität hat.

3. Korpuskularstrahl-Austastsystem nach Anspruch 1 oder 2, dadurch gekennzeichnet, dass der Potentialsattel in radialer Richtung möglichst flach ist.

4. Korpuskularstrahl-Austastsystem nach einem der Ansprüche 1 bis 3, dadurch gekennzeichnet, dass das strahlquellenbezogene Potential des Sattelpunkts im Sperrbetrieb leicht in der Richtung des Vorzeichens der physikalischen Ladung der geladenen Korpuskeln vom Strahlquellenpotential abweicht.

5. Korpuskularstrahl-Austastsystem nach einem der Ansprüche 1 bis 4, dadurch gekennzeichnet, dass nach der Austastlinse (1) in einem Zwischenbild der Quelle (2) eine Austast-Lochblende (4) angeordnet ist, wobei der Durchmesser $d_{AB}$ der Austast-Lochblende $d_{AB} = M \cdot d_Q$ dem Quellendurchmesser $d_Q$ angepasst ist, wobei M die Vergrösserung der Quelle bis zum Zwischenbild ist.

6. Korpuskularstrahl-Austastsystem nach einem der Ansprüche 1 bis 4, gekennzeichnet durch die Abbildung von Formstrahlblenden auf das Target, wobei die Formstrahlblenden nach dem Austastsystem angeordnet sind.

7. Korpuskularstrahl-Austastsystem nach einem der Ansprüche 1 bis 6, dadurch gekennzeichnet, dass an die Mittelelektrode noch eine Zusatzgleichspannung angelegt ist, deren Vorzeichen dem Vorzeichen der physikalischen Ladung der geladenen Korpuskeln entspricht.

**Claims**

1. A corpuscular beam gating system for producing a pulsed corpuscular beam probe, characterised by an individual electrostatic three-electrode lens (1) as a gating lens, whose electrodes are designed in accordance with a filter lens, the central electrode lies approximately at the potential of the beam source during the transmission operation being fed with the gating signal by means of a capacitor, and the main point $H_G$ on the object side coinciding with the virtual source image which belongs to this gating lens.

2. A corpuscular beam gating system as claimed in Claim 1, characterised in that the gating lens has small radial dimensions and a low capacitance.

3. A corpuscular beam gating system as claimed in Claim 1 or 2, characterised in that there is a potential through that is as flat as possible in the radial direction.

4. A corpuscular beam gating system as claimed in one of Claims 1 to 3, characterised in that during blocking operation the potential of the through point related to the beam source differs from the beam source potential in the direction of the preceding sign of the physical charge of the charged beam particles.

5. A corpuscular beam gating system as claimed in one of Claims 1 to 4, characterised in that behind the gating lens (1) in an intermediate image of the source (2), there is arranged a gating aperture (4), whose diameter $d_{AB}$ is matched to the source diameter $d_Q$ such that $d_{AB} = M \cdot d_Q$, where M is the enlargement of the source to the intermediate image.

6. A corpuscular beam gating system as claimed in one of Claims 1 to 4, characterised by the representation of form beam diaphragms on the target, the form beam diaphragms being arranged in accordance with the gating system.

7. A corpuscular beam gating system as claimed in one of Claims 1 to 6, characterised in that there is connected to the central electrode an additional d.c. voltage, whose preceding sign corresponds to the preceding sign of the physical charge of the charged beam particles.

**Revendications**

1. Système de suppression de faisceau corpusculaire servant à produire des impulsions pour une sonde à faisceau corpusculaire, caractérisé par une lentille électrostatique unipotentielle (1) servant de lentille de suppression, dont les électrodes sont agencés à la manière d'une lentille filtre, le signal de suppression étant envoyé par l'intermédiaire d'un condensateur à l'électrode centrale placée, pendant le fonctionnement à la transmission, approximativement au potentiel de la source de rayonnement, et cette lentille de suppression étant insérée sur le trajet du rayonnement de telle sorte que le point principal objet ($H_G$) coïncide avec l'image virtuelle de la source qui est associée à cette lentille de supression.

2. Système de suppression de faisceau corpusculaire suivant la revendication 1, caractérisé par le fait que la lentille de suppression possède de faibles dimensions radiales et une faible capacité.

3. Système de suppression de faisceau corpusculaire suivant la revendication 1 ou 2, caractérisé par le fait que la cuvette de potentiel est aussi plate que possible suivant la direction radiale.

4. Système de suppression de faisceau corpusculaire suivant l'une des revendications 1 à 3, caractérisé par le fait que le potentiel, rapporté à la source de rayonnement, de la cuvette de potentiel pendant le fonctionnement avec blocage s'écarte légèrement du potentiel de la source de rayonnement, dans la direction correspondant au signe de la charge des corpuscules chargés.

5. Système de suppression de faisceau corpusculaire suivant l'une des revendications 1 à 4, caractérisé par le fait qu'un diaphragme perforé de suppression (4) est disposé, en aval de la lentille de suppression (1), au niveau de l'image intermédiaire de la source (2), le diamètre $d_{AB}$ du diaphragme perforé de suppression étant adapté au diamètre $d_Q$ de la source conformément à $d_{AB} = M \cdot d_Q$, M étant le grandissement de la source jusqu'à l'image intermédiaire.

6. Système de suppression de faisceau corpusculaire suivant l'une des revendications 1 à 4, caractérisé par la formation de l'image de diaphragme de mise en forme du faisceau sur la cible, ces diaphragmes étant disposés en aval du système de suppression.

7. Système de suppression de faisceau corpusculaire suivant l'une des revendications 1 à 6, caractérisé par le fait qu'à l'électrode centrale est encore appliquée une tension continue supplémentaire dont le signe correspond au signe de la charge physique des corpuscules chargés.

FIG 1

FIG 2

a)

b)

FIG 3a

FIG 3b

FIG 4a

FIG 4b